(19) **Europäisches Patentamt / European Patent Office / Office européen des brevets**

(11) **EP 3 878 802 B1**

(12) **FASCICULE DE BREVET EUROPEEN**

(45) Date de publication et mention de la délivrance du brevet:
**29.04.2026 Bulletin 2026/18**

(21) Numéro de dépôt: **21160761.9**

(22) Date de dépôt: **04.03.2021**

(51) Classification Internationale des Brevets (IPC):
**H01L 21/02** *(2006.01)* **B81B 7/00** *(2006.01)*
**B81C 1/00** *(2006.01)*

(52) Classification Coopérative des Brevets (CPC):
**B81C 1/00158; H10P 54/52; H10P 90/00;**
B81C 2201/0192

(54) **PROCEDE DE SUSPENSION D'UNE COUCHE MINCE SUR UNE CAVITE AVEC EFFET RAIDISSEUR OBTENU PAR PRESSURISATION DE LA CAVITE PAR DES ESPECES IMPLANTEES**

VERFAHREN ZUR AUFHÄNGUNG EINER DÜNNSCHICHT ÜBER EINEM HOHLRAUM MIT EINEM VERSTEIFUNGSEFFEKT, DER DURCH DRUCKAUFBAU IN DIESEM HOHLRAUM MIT IMPLANTIERTEN ARTEN ERZIELT WIRD

METHOD FOR HANGING A THIN LAYER ON A CAVITY WITH STIFFENING EFFECT OBTAINED BY PRESSURISATION OF THE CAVITY BY IMPLANTED SPECIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.03.2020 FR 2002343**

(43) Date de publication de la demande:
**15.09.2021 Bulletin 2021/37**

(73) Titulaire: **Commissariat à l'Energie Atomique et aux Energies Alternatives**
**75015 Paris (FR)**

(72) Inventeurs:
• **BERRE, Guillaume**
**38054 GRENOBLE CEDEX 09 (FR)**

• **MAZEN, Frédéric**
**38054 GRENOBLE CEDEX 09 (FR)**
• **SALVETAT, Thierry**
**38054 GRENOBLE CEDEX 09 (FR)**
• **RIEUTORD, François**
**38054 GRENOBLE CEDEX 09 (FR)**

(74) Mandataire: **Santarelli**
**Tour Trinity**
**1 bis Place de la Défense**
**92400 Courbevoie (FR)**

(56) Documents cités:
**EP-A1- 3 401 273      WO-A1-2006/032948**
**WO-A1-2015/119564   WO-A2-2012/145485**
**FR-A1- 3 074 358       US-A1- 2018 346 321**

## Description

## DOMAINE TECHNIQUE

Le domaine de l'invention est celui de la conception de substrats contenant des cavités enterrées. L'invention concerne plus particulièrement le transfert d'une couche mince pour la suspendre sur une cavité initialement ouverte et ainsi sceller la cavité.

## TECHNIQUE ANTÉRIEURE

La fabrication de cavités enterrées passe par la suspension d'une couche mince (de quelques nanomètres à quelques microns d'épaisseur) sur des cavités de tailles et géométries variables, de quelques microns pour des applications de type résonateur microélectromécanique à quelques centaines de microns pour des applications de type assemblage (*packaging*) microélectronique.

Le procédé le plus courant pour réaliser cette suspension est celui de l'amincissement d'un substrat de silicium ou encore d'un silicium sur isolant (SOI). D'autres procédés font appel à des technologies de collage, perçage d'un substrat et attaque chimique du substrat pour usiner les cavités. Ces techniques, bien que maitrisées, sont problématiques en termes de coût (consommation complète d'un substrat Si ou pire d'un substrat SOI), de temps (procédé d'amincissement long) et d'épaisseur de couche mince.

La technologie Smart Cut™ est une technique largement développée depuis environ deux décennies pour permettre le transfert de couches minces de matériaux semiconducteurs. Selon cette technique, des espèces ioniques telles que de l'hydrogène et/ou de l'hélium sont implantées dans un substrat donneur afin d'y former un plan de fragilisation. Le substrat donneur est par la suite mis en contact avec un substrat support, par exemple par collage direct. Cette technique fait ensuite appel au développement des défauts générés au niveau du plan de fragilisation. Ce développement implique un apport énergétique, généralement réalisé au moyen d'un traitement thermique de quelques centaines de degrés, 500°C typiquement, pendant quelques dizaines de minutes. Cela conduit à la formation d'une couche confinée de cavités et de microfissures au sein de laquelle va s'initier et se propager une fracture. Cette fracture sépare le substrat donneur le long du plan de fragilisation et une couche mince du substrat donneur est ainsi transférée sur le substrat support.

Cependant, ce procédé ne peut pas être directement utilisé pour réaliser la suspension d'une couche mince sur une cavité de taille quelconque. La publication de C-H Yun et N.W.Cheung, « Fabrication of Silicon and Oxide Membranes Over Cavities Using Ion-Cut Layer Transfer", Journal of Microelectromechanical Systems, vol. 9, no. 4, december 2000, montre en effet qu'une membrane d'épaisseur donnée ne peut être transférée avec succès que sur des cavités dont la taille est inférieure à une taille limite. Cela est lié au fait que, dans la cavité, il n'y a pas d'effet raidisseur. Une cloque peut donc se développer en entraînant une déformation de la membrane, laquelle peut se briser (exfoliation) ce qui conduit à l'échec local du transfert.

Du fait de ce phénomène d'exfoliation, le transfert sur cavités par Smart Cut™ se voit donc restreint en pratique à des cavités de quelques microns, voire de quelques dizaines de microns, en fonction de différents paramètres et en particulier de la profondeur d'implantation.

FR 3 074 358 A1 divulgue un procédé de réalisation d'une cavité étanche à couche mince.

WO 2015/119564 le contrôle de la pression dans des cavités sur un substrat.

EP 3 401 273 décrit un procédé de réalisation d'un dispositif MEMS utilisant plusieurs qualités, ayant des atmosphères différentes.

US 2018/0346321 décrit un dispositif MEMES dans une cavité duquel on peut fixer une pression.

WO 2012/145485 décrit une implantation de produits chimiques gazeux dans des cavités formées dans des couches diélectriques intermédiaires en vue d'un dégagement subséquent par thermodiffusion.

## EXPOSÉ DE L'INVENTION

L'invention a pour objectif de proposer une technique de scellement d'une cavité au moyen d'un report d'une couche mince sur la cavité par Smart Cut™, technique qui serait applicable au scellement de cavités de tailles plus importantes.

Il est proposé un procédé de transfert d'une couche semiconductrice d'un substrat donneur vers un substrat receveur présentant une cavité ouverte, comprenant les étapes de formation d'un plan de fragilisation dans le substrat donneur et de réalisation, par mise en contact du substrat donneur et du substrat receveur, d'un assemblage dans lequel ladite cavité est enterrée. Le procédé comprend, préalablement à la réalisation de l'assemblage, une étape d'implantation dans le substrat donneur ou dans le substrat receveur d'espèces gazeuses et, postérieurement à la réalisation de l'assemblage, une étape de diffusion desdites espèces dans la cavité.

Il est également proposé un procédé de transfert d'une couche semiconductrice d'un substrat donneur vers un substrat receveur présentant une cavité ouverte, comprenant les étapes de :

- formation d'un plan de fragilisation dans le substrat donneur ;
- réalisation, par mise en contact du substrat donneur et du substrat receveur, d'un assemblage dans lequel ladite cavité est enterrée ;
- séparation de l'assemblage par fracture le long du plan de fragilisation, ladite séparation entrainant le transfert de la couche semiconductrice vers le substrat receveur et le scellement de la cavité par la couche semiconductrice ;

comprenant, préalablement à la réalisation de l'assemblage, une étape d'implantation dans le substrat donneur ou dans le substrat receveur d'espèces diffusantes et, postérieurement à la réalisation de l'assemblage et préalablement à la séparation de l'assemblage, une étape de diffusion desdites espèces dans la cavité.

Certains aspects préférés mais non limitatifs de ce procédé sont les suivants :

l'étape de diffusion desdites espèces dans la cavité comprend un recuit de l'assemblage ;
ledit recuit est poursuivi jusqu'à séparation de l'assemblage par fracture le long du plan de fragilisation ;
lesdites espèces sont implantées dans le substrat receveur à une profondeur inférieure à la profondeur du plan de fragilisation dans le substrat donneur ;
les espèces diffusantes ne sont pas implantées à travers le fond de la cavité ;
les espèces diffusantes sont implantées dans le substrat donneur à une profondeur inférieure à la profondeur du plan de fragilisation.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

[Fig. 1] est un schéma illustrant des défauts de type microfissures se développant en présence d'un raidisseur ;
[Fig. 2] est un schéma illustrant des défauts de type cloques se développant en l'absence d'un raidisseur ;
[Fig. 3] est un schéma illustrant les différentes étapes d'un procédé selon l'invention ;
[Fig. 4] est un schéma illustrant le phénomène de croissance verticale des défauts dans la cavité en l'absence de la mise en œuvre de l'invention ;
[Fig. 5] est un schéma illustrant le phénomène de croissance latérale des défauts par contre-pression de la cavité du fait de la mise en œuvre de l'invention.

## DESCRIPTION DES MODES DE RÉALISATION

Lors du recuit de fracture du procédé Smart Cut™, l'espèce introduite au préalable par implantation ionique pour former le plan de fragilisation va réagir et former des défauts à une certaine profondeur dans le substrat donneur. Ces défauts sont pressurisés et leur évolution dépend de la rigidité du système (effet raidisseur).

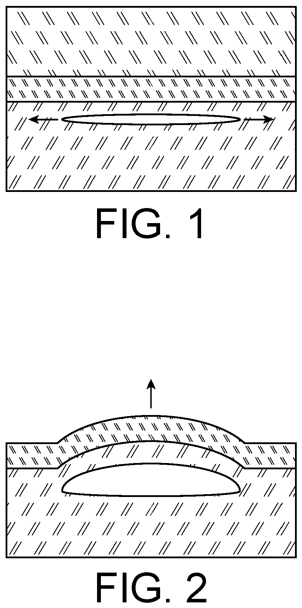

Comme représenté sur la figure 1, en présence d'un effet raidisseur, apporté par un substrat collé au substrat donneur ou par un dépôt épais sur celui-ci, les défauts se développent sous la forme de microfissures qui se propagent préférentiellement latéralement et peuvent atteindre des tailles de quelques centaines de microns.

Comme représenté sur la figure 2, en l'absence d'un effet raidisseur, la surface du substrat étant laissée libre, les défauts se développent sous la forme de cloques qui se propagent horizontalement et verticalement, leur croissance étant bornée par le phénomène d'exfoliation correspondant à leur décapsulation.

La taille maximale des cloques, et donc la taille des exfoliations, est critique dans le procédé de transfert sur cavité car ce mode de croissance est présent dans les cavités lors du recuit de fracture. Ainsi, s'il y a une exfoliation avant le passage de la fracture, la cavité sera systématiquement percée.

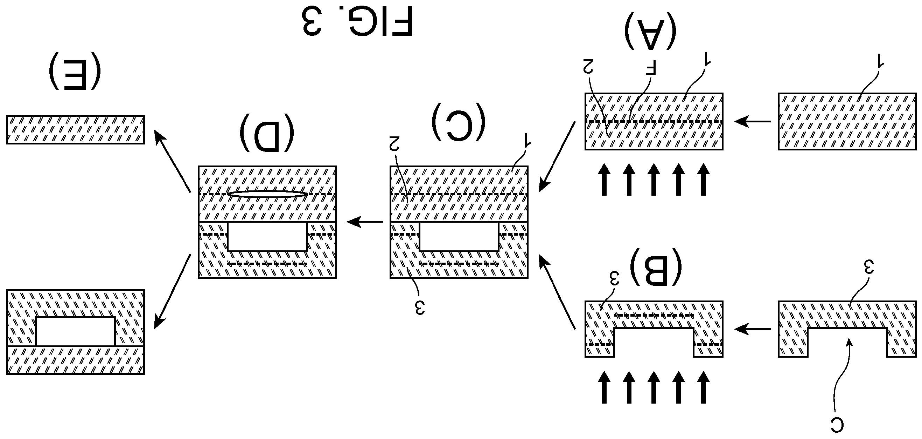

En référence à la figure 3, l'invention porte sur un procédé de transfert d'une couche semiconductrice 2 d'un substrat donneur 1 vers un substrat receveur 3. Le substrat receveur comporte au moins une cavité ouverte C, par exemple issue de gravure, et le transfert de la couche semiconductrice vise à sceller cette cavité. L'invention trouve application à la fabrication de tout type de dispositif s'appuyant sur l'utilisation d'une membrane suspendue, comme par exemple les transducteurs ultrasoniques micro-usinés de type capacitif (cMUT pour « capacitive Micromachined Ultrasonic Transducers »).

Le substrat receveur peut présenter une pluralité de cavités ouvertes, ces cavités pouvant potentiellement présenter des tailles et/ou des géométries différentes. La couche mince transférée vient alors recouvrir tout ou partie des cavités du substrat receveur.

Le substrat donneur peut comprendre une structure multicouche, par exemple une structure multicouche multi-matériaux (par exemple un dépôt d'oxyde ou de nitrure de silicium, des dépôts métalliques fins ou d'autre dépôts fonctionnels). Ces dépôts peuvent être réalisés avant l'implantation ionique (tout en restant compatible avec celle-ci) ou après l'implantation ionique (mais dans ce cas, ils ne doivent pas faire appel à des budgets thermiques pouvant entrainer la maturation des défauts au niveau de la zone implantée ; ils sont ainsi typiquement réalisés à une température inférieure à 400°C, avantageusement inférieure ou égale à 350°C).

Le procédé selon l'invention comprend une étape (A) de formation d'un plan de fragilisation F dans l'épaisseur du substrat donneur 1 au moyen d'une implantation d'espèces ioniques, par exemple de l'hydrogène et/ou de l'hélium. Ce plan de fragilisation délimite une portion superficielle du substrat donneur qui va former la couche mince à transférer 2 d'une partie massive du substrat donneur.

Le procédé comprend une étape (B) d'implantation dans le substrat receveur d'espèces gazeuses, dites diffusantes car aptes à diffuser dans le matériau du substrat receveur sous l'effet notamment d'un traitement thermique.

Cette implantation (B) est de préférence de faible profondeur. La profondeur d'implantation des espèces diffusantes dans le substrat receveur est de préférence inférieure à la profondeur du plan de fragilisation F formé dans le substrat donneur. La profondeur d'implantation des espèces diffusantes peut ainsi être comprise entre 5 nm et 200nm. Notamment, la profondeur d'implantation des espèces diffusantes est de préférence inférieure à la profondeur de la cavité. Ces critères de profondeur permettent lors d'un recuit ultérieur de maximiser la diffusion des espèces diffusantes dans la cavité avant la maturation des défauts au niveau du plan de fragilisation du substrat donneur.

Dans un mode de réalisation privilégié, on procède lors de cette étape (B) à une implantation d'hélium.

L'implantation des espèces diffusantes peut être réalisée au travers un masque pour limiter l'implantation aux zones du substrat receveur dépourvues de cavités et ainsi ne pas implanter lesdites espèces diffusantes à travers le fond de la ou des cavités.

Cette implantation peut par ailleurs être réalisée selon la technique de l'implantation par immersion plasma afin d'obtenir une bonne répartition des espèces implantées, notamment à proximité de la surface (entre 5nm et 200nm de profondeur).

Dans une variante de réalisation, les espèces diffusantes sont implantées, non pas dans le substrat receveur, mais dans le substrat donneur. La profondeur d'implantation des espèces diffusantes est inférieure à la profondeur d'implantation des espèces ioniques conduisant à la formation du plan de fragilisation.

Le procédé comprend ensuite une étape de réalisation (C), par mise en contact du substrat donneur 1 et du substrat receveur 3, d'un assemblage dans lequel ladite cavité est enterrée. La mise en contact des substrats 1,3 est ainsi réalisée de telle manière que la couche mince 2 vienne sceller la cavité. L'assemblage du substrat donneur 1 et du substrat support 3 peut être réalisé par l'intermédiaire d'une couche préalablement déposée sur l'un et/ou l'autre des substrats 1, 3, comme par exemple une couche diélectrique ou métallique ou une couche contrainte.

Le procédé comprend une étape (D) de diffusion des espèces diffusantes dans la cavité. Cette étape de diffusion peut comprendre un recuit de l'assemblage (dont la température et la durée peuvent être celles du recuit de fracture). Les espèces gazeuses diffusées dans la cavité viennent la pressuriser. Cette pression permet d'exercer un effet raidisseur dans la cavité et empêche ou limite le développement de cloques au niveau du plan de fragilisation à l'aplomb de la cavité. Ledit recuit peut être poursuivi jusqu'à séparation de l'assemblage (E) par fracture le long du plan de fragilisation.

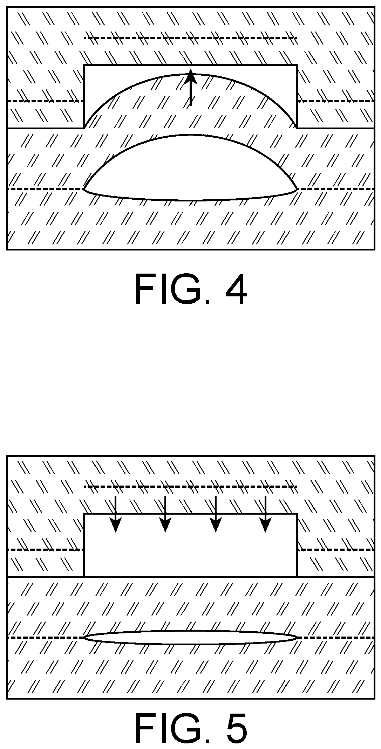

Ainsi, le procédé de l'invention vient mettre en œuvre une contre-pression dans la cavité afin de contraindre les défauts de type cloques à se propager latéralement. Sous l'effet de cette contre-pression, les conditions d'exfoliations sont modifiées et la croissance des défauts se rapproche d'une croissance latérale comme pour les microfissures. On a représenté sur la figure 4 un schéma illustrant le phénomène de croissance verticale des défauts dans la cavité en l'absence de la mise en œuvre de l'invention. La figure 5 illustre quant à elle le phénomène de croissance latérale des défauts par contre-pression de la cavité du fait de la mise en œuvre de l'invention.

Ainsi, le transfert sur cavité selon l'invention n'est plus limité par le phénomène d'exfoliation et, à épaisseur de film transféré fixée, il est possible de réaliser le scellement de cavités de beaucoup plus grandes tailles que dans l'état de l'art.

La description ci-après porte sur une méthode permettant de quantifier la dose nécessaire d'espèces diffusantes à implanter pour obtenir la contre-pression nécessaire. Cette méthode prend l'exemple d'une formation du plan de fragilisation par implantation d'hydrogène dans le substrat donneur et d'une implantation d'hélium en tant qu'espèce diffusante dans le substrat receveur.

Afin de quantifier la dose nécessaire en hélium, il faut quantifier la quantité d'hydrogène présente dans les cloques avant le passage de la fracture. Pour ce faire, il faut décrire en fonction des dimensions de la cavité la taille maximum des cloques qui seront présentes. Prenons pour exemple une cavité cible prenant la forme d'un cylindre de hauteur a et la base présentant un diamètre L. La cloque qui va se développer avant fracture aura donc un rayon maximum R de L/2.

Afin de déterminer la dose X en hélium (noté $D_{tot2}$) à implanter, il faut comparer la pression dans la cloque avec la pression dans la cavité. Pour déterminer la pression dans la cloque, on exprime la géométrie d'une cloque selon la théorie de l'élasticité des plaques et des cloques développée par Timoshenko.

La flèche maximum de la cloque est donnée par

$$h_{Max} = \frac{3}{16} * \frac{1-v^2}{Ee^3} P_1 R^4$$ où E est le module d'Young du matériau constituant la couche mince transférée, v est son coefficient de Poisson, $P_1$ correspond à la pression dans la cloque, R au rayon de la cloque et e à l'épaisseur de la couche mince transférée. Le volume de la cloque s'exprime alors selon

$$V_{cloque} = \frac{\pi}{3} h_{Max} R^2.$$

En faisant l'hypothèse qu'une fraction $\alpha$ de la dose en hydrogène (notée $D_{tot1}$) implantée dans le substrat donneur se retrouve dans la cloque, on retrouve dans la cloque une dose d'hydrogène $D_1 = \alpha D_{tot1}$ et une quantité d'hydrogène $N_1 = \alpha D_{tot1} \frac{\pi}{4} L^2$. Par application de la loi des gaz parfaits on obtient une formule de

la pression $P_1$ dans la cloque : $P_1 = \frac{N_1 k_B T}{V_{cloque}}$ où $k_B$ désigne la constante de Boltzmann, soit

$$P_1^2 = \frac{\alpha D_{tot_1} k_B T}{\frac{1}{16} * \frac{1-v^2}{Ee^3}(\frac{L}{2})^4}.$$

Pour déterminer la dose $D_{tot_2}$ d'hélium à implanter dans le substrat receveur, il faut exprimer la géométrie de la cavité : $V_{cavité} = a\frac{\pi}{4}L^2$ .

En faisant l'hypothèse que toute la dose implantée en hélium va pressuriser la cavité du fait de la diffusion de l'hélium dans le silicium, on obtient une quantité d'hélium dans la cavité $N_2 = D_{tot_2}\frac{\pi}{4}L^2$ . Par application de la loi des gaz parfaits, on obtient une formule de la pression $P_2$ dans la cavité :

$$P_2 = \frac{D_{tot_2} k_B T}{a}.$$

Pour obtenir une pression dans les cavités suffisante pour favoriser la propagation latérale des cloques, il faut a minima que $P_1 = P_2$. En égalisant les formules de pression, on obtient :

$$\frac{\alpha D_{tot_1} k_B T}{\frac{1}{16} * \frac{1-v^2}{Ee^3}(\frac{L}{2})^4} = \left(\frac{D_{tot_2} k_B T}{a}\right)^2$$

On en déduit un lien entre la dose d'hélium à implanter en fonction de la profondeur de la cavité (a), le diamètre de la cavité (L), les propriétés du matériau de la couche mince (E,v) et la dose d'hydrogène

$$(D_{tot_1}) : D_{tot_2} = \frac{16a}{L^2} * \sqrt{\frac{Ee^3}{(1-v^2)} * \frac{1}{k_B T} * \alpha D_{tot_1}}$$

.

Afin d'illustrer ces formules par un cas pratique, on considère la suspension d'un film mince de 1,4um de silicium en utilisant une implantation d'hydrogène dans le substrat receveur avec une dose $D_{tot1}=6*10^{16}$at/cm$^2$ et une énergie de 160keV. En prenant les paramètres E=130GPa, v =0.28, L= 40$\mu$m, a=350nm, T=500°C, $\alpha$ = 30% on obtient comme dose en hélium à implanter $D_{tot1}=2,8*10^{16}$at/cm$^2$.

## Revendications

1. Procédé de transfert d'une couche semiconductrice d'un substrat donneur (1) vers un substrat receveur (3) présentant une cavité ouverte (C), comprenant les étapes de :

- formation d'un plan de fragilisation (F) dans le substrat donneur (1) par implantation d'espèces ioniques ;
- réalisation, par mise en contact du substrat donneur (1) et du substrat receveur (3), d'un assemblage dans lequel ladite cavité est enterrée ;
- séparation de l'assemblage par fracture le long du plan de fragilisation (F), ladite séparation entrainant le transfert de la couche semiconductrice vers le substrat receveur (3) et le scellement de la cavité par la couche semiconductrice ;

**caractérisé en ce qu'**il comprend :

- préalablement à la réalisation de l'assemblage, une étape d'implantation dans le substrat donneur ou dans le substrat receveur d'espèces diffusantes, et,
- postérieurement à la réalisation de l'assemblage et préalablement à la séparation de l'assemblage, une étape de diffusion desdites espèces dans la cavité, pressurisant ainsi la cavité enterrée et formant un effet raidisseur dans la cavité qui empêche ou limite un développement de cloques au niveau du plan de fragilisation (F) à l'aplomb de la cavité lors de l'étape de séparation par fracture, contraignant les défauts de type cloque à se propager latéralement.

2. Procédé selon la revendication 1, dans lequel l'étape de diffusion desdites espèces dans la cavité comprend un recuit de l'assemblage.

3. Procédé selon la revendication 2, dans lequel ledit recuit est poursuivi jusqu'à la séparation de l'assemblage par fracture le long du plan de fragilisation.

4. Procédé selon l'une des revendications 1 à 3, dans lequel les espèces diffusantes sont implantées dans le substrat receveur à une profondeur inférieure à la profondeur du plan de fragilisation dans le substrat donneur.

5. Procédé selon la revendication 4, dans lequel les espèces diffusantes ne sont pas implantées à travers le fond de la cavité.

6. Procédé selon l'une des revendications 1 à 3, dans lequel les espèces diffusantes sont implantées dans le substrat donneur à une profondeur inférieure à la profondeur du plan de fragilisation.

7. Procédé selon l'une quelconque des revendications 1 à 6, dans lequel, lors de l'étape d'implantation d'espèces diffusantes, une dose $D_{tot2}$ d'espèces diffusantes à implanter vérifie a minima la relation :

$$D_{tot_2} = \frac{16a}{L^2} * \sqrt{\frac{Ee^3}{(1-v^2)} * \frac{1}{k_B T}} * \alpha D_{tot_1}$$ , où :

- a et L sont une profondeur et un diamètre de la cavité ;
- E et v sont le module d'Young et le coefficient de Poisson du matériau de la couche semiconductrice transférée, et e est son épaisseur ;
- $k_B$ est la constante de Boltzmann ;
- T est une température lors de l'étape de séparation ;
- $D_{tot1}$ est une dose d'espèces ioniques implantées dans le substrat donneur (1) lors de l'étape de formation du plan de fragilisation (F), et $\alpha$ est une fraction de la dose d'espèces ioniques implantées $D_{tot1}$ qui se retrouve dans la cloque.

**Patentansprüche**

1. Verfahren zum Transferieren einer Halbleiterschicht von einem Spendersubstrat (1) auf ein Aufnahmesubstrat (3), das einen offenen Hohlraum (C) beinhaltet, umfassend folgende Schritte:

    - Bilden einer Versprödungsebene (F) in dem Spendersubstrat (1) durch Implantieren ionischer Arten;
    - Herstellen einer Verbindung, in der der Hohlraum vergraben ist, durch Inkontaktbringen des Spendersubstrats (1) und des Aufnahmesubstrats (3);
    - Trennen der Verbindung durch Bruch entlang der Versprödungsebene (F), wobei das Trennen den Transfer der Halbleiterschicht auf das Aufnahmesubstrat (3) und die Versiegelung des Hohlraums durch die Halbleiterschicht bewirkt;

    **dadurch gekennzeichnet, dass** es Folgendes umfasst:

    - vor dem Durchführen der Montage einen Schritt des Implantierens in das Spendersubstrat oder in das Aufnahmesubstrat diffuser Arten, und
    - nach dem Herstellen der Verbindung und vor dem Trennen der Verbindung einen Schritt des Verteilens der Arten in den Hohlraum, wodurch der vergrabene Hohlraum unter Druck gesetzt wird und eine Versteifungswirkung in dem Hohlraum entsteht, die die Entwicklung von Bläschen auf der Versprödungsebene (F) senkrecht zu dem Hohlraum während des Schritts des Trennens durch Bruch verhindert oder begrenzt, wodurch die bläschenartigen Defekte gezwungen werden, sich seitlich auszubreiten.

2. Verfahren nach Anspruch 1, wobei der Schritt des Verteilens der Arten in den Hohlraum ein Glühen der Verbindung umfasst.

3. Verfahren nach Anspruch 2, wobei das Glühen bis zum Trennen der Verbindung durch Bruch entlang der Versprödungsebene fortgesetzt wird.

4. Verfahren nach einem der Ansprüche 1 bis 3, wobei die diffusen Arten in dem Aufnahmesubstrat in einer Tiefe implantiert werden, die geringer ist als die Tiefe der Versprödungsebene in dem Spendersubstrat.

5. Verfahren nach Anspruch 4, wobei die diffusen Arten nicht durch den Boden des Hohlraums implantiert werden.

6. Verfahren nach einem der Ansprüche 1 bis 3, wobei die diffusen Arten in dem Spendersubstrat in einer Tiefe implantiert werden, die geringer ist als die Tiefe der Versprödungsebene.

7. Verfahren nach einem der Ansprüche 1 bis 6, wobei während des Schritts des Implantierens diffuser Arten eine Dosis $D_{tot2}$ der zu implantierenden diffusen Arten mindestens folgende Beziehung überprüft:

$$D_{tot_2} = \frac{16a}{L^2} * \sqrt{\frac{Ee^3}{(1-v^2)} * \frac{1}{k_B T}} * \alpha D_{tot_1}$$ , wobei:

    - a und L eine Tiefe und ein Durchmesser des Hohlraums sind;
    - E und v der Young-Modul und der Poisson-Koeffizient des Materials der übertragenen Halbleiterschicht sind, und e deren Dicke ist;
    - $k_B$ die Boltzmann-Konstante ist;
    - T eine Temperatur während des Schritts des Trennens ist;
    - $D_{tot1}$ eine Dosis der in dem Spendersubstrat (1) implantierten ionischen Arten während der Phase des Bildens der Versprödungsebene (F) ist, und $\alpha$ ein Bruchteil der Dosis der implantierten ionischen Arten $D_{tot1}$ ist, die in dem Bläschen zurückbleibt.

**Claims**

1. A method for transferring a semiconductor layer from a donor substrate (1) to a receiver substrate (3) having an open cavity (C), comprising the steps of:

    - forming an embrittlement plane (F) in the donor substrate (1) by implanting ionic species;
    - making, by contacting the donor substrate (1) and the receiver substrate (3), an assembly in which said cavity is buried;
- separating the assembly by fracturing along the embrittlement plane (F), said separation causing transfer of the semiconductor layer to the receiving substrate (3) and sealing of the cavity by the semiconductor layer;

**characterized in that** it comprises:

- prior to making the assembly, a step of implanting diffusing species in the donor substrate or in the receiver substrate, and,
- subsequently to making the assembly and prior to separating the assembly, a step of diffusing said species in the cavity, thereby pressurizing the buried cavity and forming a stiffening effect in the cavity that prevents or limits development of blisters at the embrittlement plane (F) in vertical alignment with the cavity during the fracture separation step, forcing the blister-type defects to propagate laterally.

2. The method according to claim 1, wherein the step of diffusing said species into the cavity comprises annealing the assembly.

3. The method according to claim 2, wherein said annealing is continued until the assembly is separated by fracturing along the embrittlement plane.

4. The method according to one of claims 1 to 3, wherein the diffusing species are implanted in the receiver substrate at a depth less than the depth of the embrittlement plane in the donor substrate.

5. The method of claim 4, wherein the diffuser species are not implanted through the bottom of the cavity.

6. The method according to one of claims 1 to 3, wherein the diffusing species are implanted in the donor substrate at a depth less than the depth of the embrittlement plane.

7. The method according to any one of claims 1 to 6, wherein, during the step of implanting diffusing species, a dose $D_{tot2}$ of diffusing species to be implanted at least verifies the relationship:

$$D_{tot2} = \frac{16a}{L^2} * \sqrt{\frac{Ee^3}{(1-v^2)} * \frac{1}{k_B T} * \alpha D_{tot1}} \quad , \quad \text{where:}$$

- a and L are a depth and a diameter of the cavity;
- E and v are the Young's modulus and the Poisson number of the material of the semiconductor layer transferred, and e is its thickness;
- $k_B$ is the Boltzmann constant;
- T is a temperature during the separation step;
- $D_{tot1}$ is a dose of ionic species implanted in the donor substrate (1) during the embrittlement plane formation step (F), and $\alpha$ is a fraction of the dose of ionic species implanted $D_{tot1}$ that is found in the blister.

FIG. 1

FIG. 2

FIG. 3

FIG. 4

FIG. 5

## RÉFÉRENCES CITÉES DANS LA DESCRIPTION

**Documents brevets cités dans la description**

- FR 3074358 A1
- WO 2015119564 A
- EP 3401273 A
- US 20180346321 A
- WO 2012145485 A

**Littérature non-brevet citée dans la description**

- **C-H YUN** ; **N.W.CHEUNG**. Fabrication of Silicon and Oxide Membranes Over Cavities Using Ion-Cut Layer Transfer. *Journal of Microelectromechanical Systems*, December 2000, vol. 9 (4)